# EUROPEAN PATENT SPECIFICATION

(11) **EP 1 321 982 B1**
(45) Date of publication and mention of the grant of the patent: **27.07.2011**
(21) Application number: 02102839.4
(22) Date of filing: 19.12.2002
(51) Int. Cl.: H01L 21/60

(54) **Wafer-level method of fabricating a contact pad copper cap layer**
Verfahren zur Herstellung auf Waferebene einer Kupferkappenschicht auf einer Anschlusskontaktfläche
Procédé de fabrication à l'échelle d'une tranche d'une couche de cuivre revêtant un plot de connexion

(30) Priority: 21.12.2001 US 342949 P; 26.02.2002 US 86117
(43) Date of publication of application: 25.06.2003
(73) Proprietor: Texas Instruments Incorporated, Dallas, Texas 75251 (US)
(72) Inventor: Bojkov, Christo P., Plano, TX 75025 (US); Coffman, Phillip, Rowlett, TX 75089 (US); Smith, Patricia B., Colleyville, TX 76034 (US)
(74) Representative: Holt, Michael

(56) References cited:
- EP-A- 0 917 195
- EP-A- 1 050 905
- WO-A-00/34997
- WO-A-99/34424
- DE-A1- 19 915 245
- US-A- 6 080 656

## Description

### FIELD OF THE INVENTION

The present invention is related in general to the field of semiconductor devices and processes and more specifically to the structure and fabrication method of metal bumps for flip-chip assembly of semiconductor chips.

### DESCRIPTION OF THE RELATED ART

The structure of contact pad metallizations and solder bumps for connecting integrated circuit (IC) chips to semiconductor packages or outside parts, as well as the thermomechanical stresses and reliability risks involved, have been described in a series of detailed publications by the International Business Machines Corporation in 1969 (IBM J. Res. Develop., Vol. 13, pp. 226 - 296): P. A. Totta et al., SLT Device Metallurgy and its Monolithic Extension, L. F. Miller, Controlled Collapse Reflow Chip Joining, L.S. Goldmann, Geometric Optimization of Controlled Collapse Interconnections, K. C. Norris et al., Reliability of Controlled Collapse Interconnections, S. Oktay, Parametric Study of Temperature Profiles in Chips Joined by Controlled Collapse Techniques, B. S. Berry et al., Studies of the SLT Chip Terminal Metallurgy.

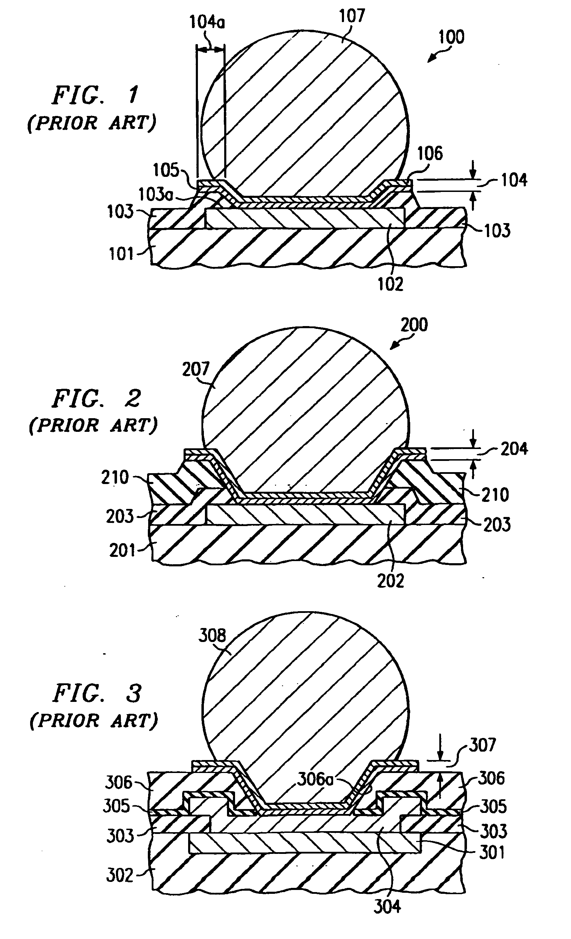

Based on these publications, FIG. 1 illustrates schematically an example of the metallurgical requirements in known technology for a contact pad of a small portion of an IC chip generally designated 100. A semiconductor material 101, typically silicon, has patterned aluminum metallization 102 and is protected by a dielectric, moisture-impermeable protective overcoat 103, usually silicon nitride or oxynitride. A window has been opened in the overcoat 103 to expose metallization 102 and leave a protective perimeter 103a around metallization 102. An additional "under bump" metallization 104 has been deposited unto metallization 102 and patterned so that it overlaps by a distance 104a over the overcoat 103. This additional metallization 104 usually consists of a sequence of thin layers. The bottom layer is typically a refractory metal 105, such as chromium, titanium, or tungsten, which provides an ohmic contact to aluminum 102 and a moisture-impenetrable interface to overcoat 103. The top metal 106 has to be solderable; examples are gold, copper, nickel, or palladium. Finally, solder material is deposited, commonly by evaporation, plating or screen-printing, and reflown to form bump 107. These solder bumps assume various shapes (examples are semi-spheres, domes and truncated balls) after the reflow process, influenced by the forces of surface tension during the reflow process.

During and after assembly of the IC chip to an outside part such as a substrate or circuit board by solder reflow, and then during device operation, significant temperature differences and temperature cycles appear between semiconductor chip 100 and the substrate. The reliability of the solder joint is strongly influenced by the coefficients of thermal expansion of the semiconductor material and the substrate material. For example, there is more than one order of magnitude difference between the coefficients of thermal expansion of silicon and FR-4. This difference causes thermomechanical stresses, which the solder joints have to absorb. Detailed calculations, in the literature cited above and in other publications of the early 1980's, involving the optimum height and volume of the solder connection and the expected onset of fatigue and cracking proposed a number of solder design solutions.

One method aims at absorbing part of the thermomechanical stress on the solder joints by plastic material surrounding the joints and filling the gap between chip and substrate. See for instance, U. S. Patents # 6,228,680, issued on May 8, 2001; # 6,213,347, issued on Apr. 10, 2001, and # 6,245,583, issued on Jun. 12, 2001 (Thomas et al., Low Stress Method and Apparatus for Underfilling Flip-Chip Electronic Devices). However, the underfilling method represents an unwelcome process step after device attachment to the motherboard.

Another method applies a polymer layer on top of the protective overcoat with the aim of reducing the stress to the overcoat perimeter and the dielectric material underlying the contact pad. See for instance the publication "A Silicon and Aluminum Dynamic Memory Technology" by Richard A. Larsen (IBM J. Res. Develop., vol.24, May 1980, pp. 268-282). The article includes description of a flip-chip packaging technology using a solder bump on an under-bump metallization, which is resting its perimeter on a thick polyimide layer. The bump structure is often supported by another polyimide layer.

FIG. 2 illustrates schematically an example of a contact pad, generally designated 200, including a polymer overcoat. A silicon chip 201 has patterned aluminum metallization 202 and is protected by a moisture-impermeable inorganic overcoat 203 (silicon nitride) and a polymeric layer 210 (benzocyclobutene or polyimide). A window has been opened through both overcoats. Layers of under-bump metallization 204 establish contact to the aluminum, adhesion to both overcoats, and solderability to the solder bump 207.

An example of a patent based on this approach of a solder ball flip-chip structure designed for stress absorption after mounting is described in the Japanese Patent # 1-209746, issued on 23 Aug. 1989 (Moriyama Yoshifumi, "Semiconductor Device"). The perimeter of the under-bump metallization of the solder ball is supported by a polyimide layer as a heat tolerant resin.

In high-speed, low electromigration IC's, aluminum has been replaced by copper as chip metallization.

EP 0917195 A1 teaches a method of forming a solder ball contact, wherein a copper layer is provided and covered with a stress relieving layer, in which an opening exposing a portion of the copper layer is formed, a copper layer is formed in the opening sputtering, a copper base is plated on to the sputtered copper layer and a solder ball is formed on the copper base.

Due to bondability and contact resistance issues of copper oxide, it is problematic to establish reliable contact to solder material.

Approaches based on adding an interface layer of aluminum, or of metals with higher affinity to oxygen than copper, are costly and not very effective. An urgent need has therefore arisen for a coherent, low-cost method of fabricating flip-chip assembly of semiconductor devices offering a fundamental solution of solder contact to copper and of thermomechanical stress reliability. The method should be flexible enough to be applied for different semiconductor product families and a wide spectrum of design and process variations. Preferably, these innovations should be accomplished using the installed equipment base so that no investment in new manufacturing machines is needed.

### SUMMARY OF THE INVENTION

A structure and a fabrication method are described for metallurgical connections between solder bumps and contact pads positioned on integrated circuits (IC) having copper interconnecting metallization protected by an overcoat. The structure comprises a portion of the copper metallization exposed by a window in the overcoat, where the exposed copper has a chemically and plasma cleaned surface. A copper layer is directly positioned on the clean copper metallization, and patterned; the resulting metal structure has an electrical (and thermal) conductivity about equal to the conductivity of pure copper. The copper layer overlaps the perimeter of the overcoat window and a copper stud is positioned on said copper layer. Finally, one of the solder bumps is bonded to the copper stud.

The present invention is related to high density and high speed ICs with copper interconnecting metallization, especially those having high numbers of metallized inputs/outputs for flip-chip assembly. These circuits can be found in many device families such as processors, digital and analog devices, logic devices, high frequency and high power devices, and in both large and small area chip categories.

It is an aspect of the present invention to be applicable to contact pad area reduction and thus supports the shrinking of IC chips. Consequently, the invention helps to alleviate the space constraint of continually shrinking applications such as cellular communication, pagers, hard disk drives, laptop computers and other portable electronic devices.

Another aspect of the invention is to fabricate the contact pad copper cap-layer directly on the IC copper metallization without any intermediate barrier layer, so that the resulting minimum electrical resistance enhances the high speed performance of the IC.

Another aspect of the invention is the flexibility to select the copper stud deposition method from the following options:
- electroplating the copper stud onto the copper layer, thereby enabling an electroplating process for depositing the solder bump, providing small pitch center-to-center bumps; or
- electroless plating the copper stud onto the copper layer, thereby enabling a screen-printing process for depositing the solder bump, or an attachment process of pre-fabricated solder balls, providing larger pitch center-to-center balls.

Another aspect of the invention is to advance the process and reliability of wafer-level functional probing by eliminating probe marks and subsequent plating difficulties.

Another object of the invention is to provide design and process concepts which are flexible so that they can be applied to many families of semiconductor products, and are general so that they can be applied to several generations of products.

Another object of the invention is to use only designs and processes most commonly employed and accepted in the fabrication of IC devices, thus avoiding the cost of new capital investment and using the installed fabrication equipment base.

These objects are addressed by the teachings of the invention concerning selection criteria and process flows suitable for mass production. Various modifications have been successfully employed to satisfy different selections of deposition and plating technologies.

In the first embodiment of the invention, after a wafer cleaning in organic solvents, an oxygen plasma removes organic residues; a subsequent first hydrogen-based plasma removes the controlled copper oxide and passivates the copper surface. Sputter etching then creates a fresh copper surface, onto which a copper layer is sputter deposited. A second hydrogen plasma passivates the surface. The plating of the copper stud completes the fabrication process.

In a second embodiment of the invention, the copper layer is sputter-deposited without breaking the vacuum after the first hydrogen plasma.

Thus, the present invention is provided by a method in accordance with claim 1.

### BRIEF DESCRIPTION OF THE DRAWINGS

FIG. 1 is a schematic and simplified cross section of a flip-chip assembly with solder bumps, as fabricated by known technology.
FIG. 2 is a schematic cross section of a solder bump and undermetal arrangement over the chip contact pad metallization according to known technology.
FIG. 3 is a schematic and simplified cross section of a solder bump and undermetal arrangement over the chip contact pad metallization with an auxiliary aluminum layer according to known technology.
FIG. 4 is a schematic and simplified cross section of a solder bump and undermetal arrangement over the chip contact pad metallization according to known technology.
FIG. 5 is a schematic and simplified cross section of a solder bump with copper seed layer and copper stud over the chip contact pad metallization useful for understanding the invention.
FIG. 6 is a block diagram of the process flow for direct bumping on copper pads according to the invention.

### DETAILED DESCRIPTION OF THE PREFERRED EMBODIMENTS

The impact of the present invention can be most easily appreciated by highlighting the shortcomings of the known approaches to form contacts to copper-metallized integrated circuits (IC). In the continuing trend to miniaturize the ICs, the RC time constant of the interconnection between active circuit elements increasingly dominates the achievable IC speed-power product. Consequently, the relatively high resistivity of the interconnecting aluminum now appears inferior to the lower resistivity of metals such as copper. Further, the pronounced sensitivity of aluminum to electromigration is becoming a serious obstacle. Consequently, there is now a strong drive in the semiconductor industry to employ copper as the preferred interconnecting metal, based on its higher electrical conductivity and lower electromigration sensitivity.

Copper has to be shielded from diffusing into the silicon base material of the ICs in order to protect the circuits from the carrier lifetime killing characteristic of copper atoms positioned in the silicon lattice. For bond pads made of copper, the formation of thin copper(I) oxide films during the manufacturing process flow has to be prevented or corrected, since these films severely inhibit reliable attachment of solder bumps. As a further difficulty, bare copper bond pads are susceptible to corrosion.

In order to overcome these problems, structures and processes have been disclosed to cap the clean copper bond pad with a layer of aluminum and thus re-construct the traditional situation of an aluminum pad. For conventional gold wire bonding, a suitable bonding process is described in U.S. Patent # 5,785,236, issued on Jul. 28, 1998 (Cheung et al., "Advanced Copper Interconnect System that is Compatible with Existing IC Wire Bonding Technology"). For solder bumps structures, FIG. 3 illustrates an example emulating the example in FIG. 2. The top copper layer 301 of the IC is located over insulating material 302 and protected by inorganic overcoat 303 (usually silicon nitride). A first window is opened in overcoat 303 to expose a portion of copper metal 301. An aluminum cap 304 is deposited over the exposed copper 301, slightly overlapping the first window perimeter of overcoat 303. An additional pad nitride layer 305 and a polymeric overcoat 306 protect the aluminum 304. A second window is opened in pad nitride 305 and polymeric overcoat 306, forming a slope 306a and exposing portion of the aluminum layer 304. One, two or more barrier layers 307 are deposited over the exposed aluminum, similar to FIG. 2. The top barrier metal is solderable and contacted by solder bump 308.

The described approach, however, has several shortcomings. First, the additional fabrication cost of the aluminum cap is not desired, since the process requires additional steps for depositing metal, patterning, etching, and cleaning. Second, the aluminum must have a barrier cap with good contact to the aluminum and solderability to the solder bump. Third, the aluminum used for the cap is soft and thus gets severely damaged by the markings of the multiprobe contacts in electrical testing. This damage, in turn, becomes so dominant in the ever decreasing size of the contact pads that the subsequent barrier deposition becomes problematic.

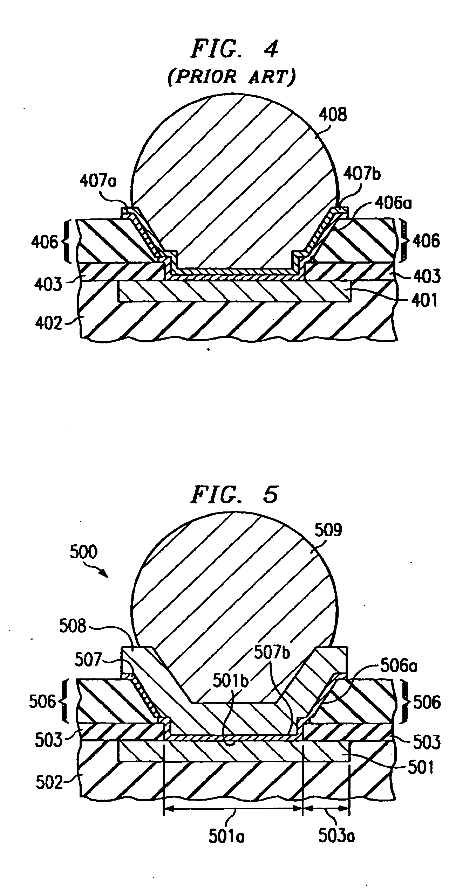

Another approach in known technology to overcome the solder attachment problems for copper metallization is depicted in FIG. 4. The top copper layer 401 of the IC is located over insulating material 402 and protected by inorganic overcoat 403 (usually silicon nitride) and polymeric overcoat 406. A window is opened in both overcoats 403 and 406, forming a slope 406a and exposing a portion of copper metal 401. A first barrier layer 407a, selected from titanium, tantalum, tungsten, and alloys thereof, is deposited over the exposed copper 401 with the intent to establish good ohmic contact to the copper by "gettering" the oxide away from the copper. A second barrier layer 407b, commonly nickel vanadium, is deposited to prevent outdiffusion of copper. From here, one process proceeds directly to screen printing the solder bump 408. Another process first sputters a copper seed layer and then electroplates a copper stud; finally, the solder bump is electroplated. In either case, the result is a contact pad with a high electrical resistance as determined by the resistance of the barrier metal layers. This high electrical pad resistance is counterproductive to the effort aiming at high speed ICs.

These shortcomings and difficulties are resolved by the process of the invention. The schematic cross section of FIG. 5 illustrates a metal structure for a contact pad, generally designated 500, of an IC having copper interconnecting metallization. The top copper layer 501 of the IC is located over insulating material 502 and protected by inorganic overcoat 503 and polymeric overcoat 506. The inorganic overcoat 503 consists preferably of moisture-impermeable silicon nitride, silicon oxynitride, silicon carbide, or multi-layers thereof, preferably in the thickness range from 0.5 to 2.5 µm. The organic overcoat 506 consists preferably of polyimide, benzocyclobutene or related materials, preferably in the thickness range from 3.0 to 10.0 µm. Overcoat 503 overlaps the copper 501 by a length 503a. The prime function of this organic material is to help absorb thermomechanical stress transferred by the solder bumps after completion of the device assembly on outside parts such as wiring boards. Overcoat 503 and especially the thicker overcoat 506 exhibit a slope 506a towards copper layer 501, brought about by the etching of the overcoats during the window opening process for exposing copper 501.

After opening the window 501a, the surface 501b of the exposed copper is carefully cleaned; see the process detail below. It is of pivotal importance to the present invention that the cleaned copper surface 501b is free of copper oxide, organic residues, or any contamination so that the interface of copper 501 to the copper layer 507 contributes no measurable electrical resistance to the resistance of contact pad 500.

The copper layer 507 (deposition techniques see below) is patterned to overlay copper surface 501b and overcoat slope 506a; the preferred thickness range of copper layer 507 is from about 0.3 to 0.8 µm. Without any contamination of copper layer 507, copper stud 508 is deposited (various deposition methods see below). The stud has a thickness from about 10 to 20 µm; its width is equal to the extent of copper layer 507, following the contour of the overcoat slope 506a. There is no longer a need for any barrier layer as in the prior art depicted in FIGs. 1 to 4.

With no contribution to the electrical resistance at interfaces 501b and 507b, the structure consisting of copper stud 508, copper layer 507, and copper metallization 501 exhibits the electrical (and thermal) conductivity of pure copper and thus the lowest possible electrical resistance for contact pad 500.

The metallurgical contact pad structure for a flip - chip IC is completed by depositing a solder bump 509; deposition methods see below. Preferred solder materials include tin, indium, tin/indium, tin/silver, tin/bismuth, conductive adhesives, and z-axis conductive materials. For some applications, the conventional tin/lead alloy may still be acceptable. When electroplating is chosen as the method of depositing the copper stud 508, electroplating is the preferred method of depositing solder bumps 509. This method allows small-pitch solder bumps. When electroless plating is chosen as the method of depositing the copper stud, screen printing is preferred for the solder bumps; alternatively, pre-fabricated solder balls may be selected. These options require somewhat larger bump pitch.

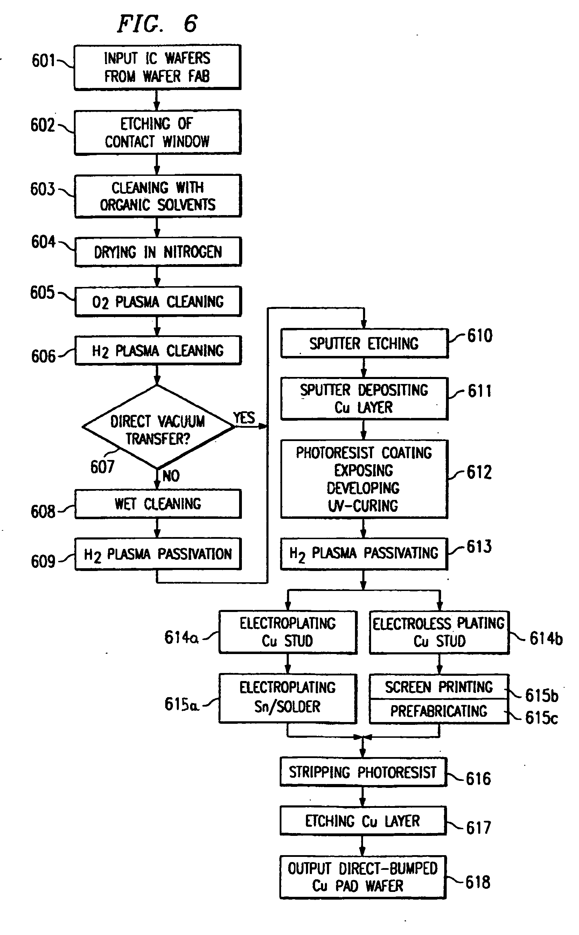

FIG. 6 shows a block diagram of the preferred wafer-level process flow for direct bumping on copper pads according to the invention; first embodiment.
- Step 601: Input: IC wafer from the wafer Fab. The wafer has copper interconnecting metallization.
- Step 602: Etching the contact window: Etching the polymeric overcoat (for instance, benzocylobutene or polyimide) using a hot wet etch in basic developer (tetramethyl ammonium hydroxide) in order to open the window for the contact pad. The wet etch results in a relatively gentle slope of the overcoat around the window perimeter towards the copper of the pad.
   Etching the inorganic overcoat (for instance, silicon nitride or silicon oxynitride) using a fluoride-containing plasma in order to expose the copper pad of the IC metallization. At this stage, the pad still has an (uncontrolled) copper oxide surface; it may further be contaminated with organic residues (such as photoresist) and/or particulates.
- Step 603: Exposing the wafer to organic solvents, thereby removing organic contamination and mechanical particles from the copper contact pads. Examples of suitable cleaning processes include:
   - submerging the wafer in agitated isopropyl alcohol, methanol, glycol, N-methyl pyrrolidone and other solvents;
   - adding ultrasonic/megasonic energy to these solvents;
   - spraying the wafer with an organic solvent;
   - treating the wafer in dry chemical vapor.
- Step 604: Drying the wafer in dry nitrogen.
- Step 605: Exposing the wafer to an oxygen and nitrogen/ helium/argon plasma, thereby ashing any further organic residues on the copper contact pads and oxidizing the copper surface to a controlled thickness of less than 10 nm. Preferred plasma pressure between 0.1 and 10 Torr at 0.2 to 1.0 mol fraction oxygen and 0 to 0.8 mol fraction helium/argon; flow rate between 2.0 and 4.0 slpm. Temperature range is between 25 and 250 °C, time from 0.5 to 5 min.
- Step 606: Without breaking the vacuum, exposing the wafer to a first hydrogen and nitrogen/helium/argon plasma, thereby removing the controlled copper oxide from the pad surface and passivating the cleaned surface. Preferred plasma pressure between 0.1 to 10 Torr at 0.2 to 1.0 mol fraction hydrogen, 0 to 0.8 mol fraction nitrogen, and 0 to 0.8 mol fraction helium/argon; flow rate between 2.0 and 4.0 slpm. Temperature range is between 25 and 25 °C, time from 0.5 to 5.0 min.
- Step 607: Deciding whether to transfer the wafer directly to further processing under vacuum, or, alternately submit it to wet cleaning.
- Step 608: Wet cleaning the wafer in order to remove the oxidized ("ashed") materials. Wet cleaning agents include, for example, dilute citric, acetic, or oxalic acids. Temperature range is between 25 and 80 °C, time from 0.5 to 15 min.
- Step 609: Exposing the wafer to a hydrogen and nitrogen/argon plasma, thereby cleaning and passivating the copper layer in the photoresist window.
- Step 610: Sputter-etching the passivated pad surface with energetic ions, thereby creating a fresh surface and concurrently activating it. Preferred plasma pressure between 5 and 100 mTorr at 750 to 1000 V bias. Temperature range is between 25 and 400 °C, time from 1.0 to 4.0 min.
- Step 611: Sputter-depositing a layer of copper covering the fresh pad surface and pad perimeter, this layer providing minimal electrical resistance and thermo-mechanical stress to the pad. This copper layer may also be referred to as "seed layer".
- Step 612: Creating a window in photoresist cover:
   - coating the wafer with photoresist;
   - exposing the window and masking the remainder;
   - developing the photoresist; and
   - ultra-violet (UV) curing the photoresist.
- Step 613: Exposing the wafer to a hydrogen and nitrogen/argon plasma, thereby cleaning and passivating the copper layer in the photoresist window.
- Step 614a and 614b: Without exposing the passivated copper layer to fresh contamination, depositing a copper stud onto the exposed copper layer. There are two options for this deposition step:
   - Step 614a: Electroplating the copper stud; or
   - Step 614b: Electroless plating the copper stud.
- Step 615a and 615b: Depositing a tin/solder bump onto the copper stud. There are two options for this deposition step:
   - Step 615a: Electroplating the tin/solder bump. This is the preferred option, when the copper stud was electroplated.
   - Step 615b: Screen-printing the tin/solder bump; or attaching a prefabricated tin/solder ball.
      Any one of these two methods is the preferred option, when the copper stud was electroless plated.
- Step 616: Stripping the photoresist.
- Step 617: Etching the copper (seed) layer.
- Step 618: Output: IC wafer with copper and tin/solder directly bumped on copper pads for optimum electrical conductivity.

In a second embodiment of the process flow, the copper layer is sputter-deposited without breaking the vacuum after the first hydrogen plasma. The wet clean (step 608) and subsequent hydrogen plasma (step 609) can thus be omitted.

## Claims

1. A wafer-level method of fabricating a contact pad copper cap layer (507+508) directly on the surface of a copper metallization (501) used as integrated circuit interconnections, comprising the ordered steps of:
(i) providing an IC wafer having copper interconnecting metallization (501) with an exposed copper contact pad (501a);
(ii) exposing (603) said wafer to organic solvents, thereby removing organic contamination and mechanical particles from said copper contact pad (501a), and drying (604a) said wafer;
(iii) exposing (605) said wafer to an oxygen plasma, thereby ashing any organic residue on said copper contact pad (501a) and oxidizing the copper surface to a controlled thickness;
(iv) without breaking the vacuum, exposing (606) said wafer to a first hydrogen based plasma, thereby removing said controlled copper oxide from the pad surface and passivating the cleaned surface;
(v) sputter-etching (610) said passivated pad surface with energetic ions, thereby creating a fresh surface and concurrently activating it;
(vi) sputter-depositing (611) a layer of copper (507) covering said fresh pad surface and pad perimeter;
(vii) exposing (613) said wafer to a second hydrogen based plasma, thereby passivating said copper layer (507); and
(viii) without exposing said passivated copper layer (507) to fresh contamination, depositing (614a, 614b) a copper stud (508) onto said copper layer (507).

2. The method according to Claim 1 further comprising the process step of depositing (615a,615b) a solder bump (509) onto said copper stud (508).

3. The method according to Claim 1 or 2 wherein said process step of depositing (614a,614b) a copper stud (508) is selected from a group of processes consisting of:
(i) electroplating (614a) said copper stud (508) onto said copper layer (507), thereby enabling an electroplating process (615a) for depositing a solder bump (509), providing small pitch center-to-center bumps; and
(ii) electroless plating (614b) said copper stud (508) onto said copper layer (507), thereby enabling a screen-printing process (614b) for depositing a solder bump (509), or an attachment process of pre-fabricated solder balls, providing large pitch center-to-center balls.

4. The method according to Claim 1, 2 or 3 wherein said process step of exposing (603) the wafer to organic solvents is selected from a group of processes consisting of:
(i) submerging said wafer in agitated isopropyl alcohol, methanol, glycol, N-methyl pyrrolidone and other solvents;
(ii) adding ultrasonic energy to said solvent;
(iii) spraying said wafer with an organic solvent; and
(iv) treating said wafer in dry chemical vapor.

5. The method according to any of Claims 1 to 4 wherein said step of sputter-depositing (611) a layer of copper (507) is performed without breaking the vacuum after said step of first hydrogen based plasma cleaning (606).

## Patentansprüche

1. Verfahren auf Wafer-Ebene zur Herstellung einer Kontaktinselkupferkappenschicht (507 + 508) unmittelbar auf der Oberfläche einer als Zusammenschaltungen integrierter Schaltungen verwendeten Kupfermetallisierung (501), mit den geordneten Schritten, bei denen:
i) ein Wafer für integrierte Schaltungen bereitgestellt wird, der eine Kupferzusammenschaltungsmetallisierung (501) mit einer freiliegenden Kupferkontaktinsel (501 a) aufweist;
ii) der Wafer organischen Lösungsmitteln ausgesetzt wird (603), wodurch organische Verunreinigungen und mechanische Partikel von der Kupferkontaktinsel (501a) entfernt werden, und der Wafer getrocknet wird (604);
iii) der Wafer einem Sauerstoffplasma ausgesetzt wird (605), wodurch ein etwaiger organischer Rückstand auf der Kupferkontaktinsel (501a) verascht wird, und die Kupferoberfläche auf eine kontrollierte Dicke oxidiert wird;
iv) der Wafer einem ersten Plasma auf Wasserstoffbasis ausgesetzt wird (606), ohne das Vakuum zusammenbrechen zu lassen, wodurch das kontrollierte Kupferoxid von der Kontaktinseloberfläche entfernt und die gereinigte Oberfläche passiviert wird;
v) die passivierte Kontaktinseloberfläche mit energiereichen Ionen sputtergeätzt wird (610), wodurch eine frische Oberfläche erzeugt und diese gleichzeitig aktiviert wird;
vi) eine Schicht aus Kupfer (507), die die frische Kontaktinseloberfläche und den Kontaktinselumfang abdeckt, durch Sputtern abgeschieden wird (611);
vii) der Wafer einem zweiten Plasma auf Wasserstoffbasis ausgesetzt wird (613), wodurch die Kupferschicht (507) passiviert wird; und
viii) ein Kupferkontaktbolzen (508) auf der Kupferschicht (507) abgeschieden wird (614a, 614b), ohne die passivierte Kupferschicht (507) einer neuen Verunreinigung auszusetzen.

2. Verfahren nach Anspruch 1, ferner mit dem Verfahrensschritt, bei dem ein Lötkontakthügel (509) auf dem Kupferkontaktbolzen (508) aufgebracht wird (615a, 615b).

3. Verfahren nach Anspruch 1 oder 2, bei dem der Verfahrensschritt, bei dem ein Kupferkontaktbolzen (508) abgeschieden wird (614a, 614b), aus einer Gruppe von Verfahren ausgewählt wird, die aus den Folgenden bestehen:
i) Galvanisieren (614a) des Kupferkontaktbolzens (508) auf die Kupferschicht (507), wodurch ein Galvanisierungsvorgang (615a) zum Abscheiden eines Lötkontakthügels (509) ermöglicht wird, der Kontakthügel mit kleinem Mittenabstand bereitstellt; und
ii) stromloses Plattieren (614b) des Kupferkontaktbolzens (508) auf die Kupferschicht (507), wodurch ein Siebdruckvorgang (615b) zum Abscheiden eines Lötkontakthügels (509) ermöglicht wird, oder ein Befestigungsvorgang vorgefertigter Lotkugeln, der Kugeln mit großem Mittenabstand bereitstellt.

4. Verfahren nach Anspruch 1, 2 oder 3, bei dem der Verfahrensschritt, bei dem der Wafer organischen Lösungsmitteln ausgesetzt wird (603), aus einer Gruppe von Verfahren ausgewählt wird, die aus den Folgenden bestehen:
i) der Wafer wird in bewegten Isopropylalkohol, Methanol, Glykol, N-Methylpyrrolidon bzw. andere Lösungsmittel eingetaucht;
ii) Ultraschallenergie wird zu dem Lösungsmittel zugefügt;
iii) der Wafer wird mit einem organischen Lösungsmittel besprüht; und
iv) der Wafer wird in trockenchemischem Dampf behandelt.

5. Verfahren nach einem der Ansprüche 1 bis 4, bei dem der Schritt, bei dem eine Schicht aus Kupfer (507) durch Sputtern abgeschieden wird (611), durchgeführt wird, ohne das Vakuum zusammenbrechen zu lassen, nach dem Schritt der Reinigung mit dem ersten Plasma auf Wasserstoffbasis (606).

## Revendications

1. Procédé de fabrication au niveau d'une tranche d'une couche de recouvrement de cuivre d'un plot de contact (507 + 508) directement sur la surface d'une métallisation de cuivre (501) utilisée comme interconnections de circuit intégré, comprenant les étapes ordonnées consistant à :
(i) fournir à une tranche d'IC qui présente une métallisation d'interconnexion de cuivre (501) un plot de contact de cuivre exposée (501a) ;
(ii) exposer (603) ladite tranche à des solvants organiques, en enlevant de ce fait une contamination organique et des particules mécaniques dudit plot de contact de cuivre (501a), et sécher (604) ladite tranche ;
(iii) exposer (605) ladite tranche à un plasma d'oxygène, en réduisant de ce fait en cendres tout résidu organique qui se situe sur ledit plot de contact de cuivre (501a) et oxyder la surface de cuivre à une épaisseur contrôlée ;
(iv) sans rompre le vide, exposer (606) ladite tranche à un premier plasma à base d'hydrogène, en éliminant de ce fait ledit oxyde de cuivre contrôlé de la surface de plot et passiver la surface nettoyée ;
(v) graver de manière ionique (610) ladite surface de plot passivée avec des ions énergétiques, en créant de ce fait une surface fraîche et en l'activant de manière simultanée ;
(vi) déposer par pulvérisation (611) une couche de cuivre (507) qui couvre ladite surface de plot fraîche et le périmètre du plot ;
(vii) exposer (613) ladite tranche à un second plasma à base d'hydrogène, en passivant de ce fait ladite couche de cuivre (507) ; et
(viii) sans exposer ladite couche de cuivre passivée (507) à une contamination fraîche, déposer (614a, 614b) un plot de cuivre (508) sur ladite couche de cuivre (507).

2. Procédé selon la revendication 1, comprenant en outre l'étape de traitement consistant à déposer (615a, 615b) une bille de soudure (509) sur ledit plot de cuivre (508).

3. Procédé selon la revendication 1 ou la revendication 2, dans lequel ladite étape de traitement consistant à déposer (614a, 614b) un plot de cuivre (508) est sélectionnée dans le groupe de traitements consistant à :
(i) plaquer par électrodéposition (614a) ledit plot de cuivre (508) sur ladite couche de cuivre (507), en permettant de ce fait à un procédé de placage par électrodéposition (615a) de déposer une bille de soudure (509), en fournissant des billes qui présentent un petit pas de centre à centre ; et
(ii) plaquer de manière anélectrolytique (614b) ledit plot de cuivre (508) sur ladite couche de cuivre (507), en permettant de ce fait à un procédé de sérigraphie (615b) de déposer une bille de soudure (509), ou à un procédé de fixation de billes de soudure préfabriquées, de fournir des billes qui présentent un grand pas de centre à centre.

4. Procédé selon l'une quelconque des revendications 1, 2 ou 3, dans lequel ladite étape de traitement consistant à exposer (603) la tranche à des solvants organiques est sélectionnée dans le groupe de traitements consistant à :
(i) plonger ladite tranche dans un alcool isopropylique agité, du méthanol, du glycol, de la N - méthylpyrrolidone et dans d'autres solvants ;
(ii) apporter une énergie ultrasonore audit solvant ;
(iii) pulvériser ladite tranche avec un solvant organique ; et
(iv) traiter ladite tranche dans une vapeur chimique sèche.

5. Procédé selon l'une quelconque des revendications 1 à 4, dans laquelle ladite étape consistant à pulvériser par dépôt (611) une couche de cuivre (507) est exécutée sans rompre le vide après ladite étape de nettoyage (606) avec un premier plasma à base d'hydrogène.
